# EUROPÄISCHE PATENTANMELDUNG

(11) **EP 2 727 875 A1**
(43) Veröffentlichungstag der Anmeldung: **07.05.2014**
(21) Anmeldenummer: 12190609.3
(22) Anmeldetag: 30.10.2012
(51) Int. Cl.: B66B 11/02

(54) **Lift mit Wartungsöffnung im Kabinenboden**

(71) Anmelder: Inventio AG, 6052 Hergiswil NW (CH)
(72) Erfinder: Trottmann, Gilles, 6405 Immensee (CH)
(74) Vertreter: Hirschberger, Petra

(57) **Zusammenfassung**

Die Erfindung betrifft einen Lift (10), der einen Antrieb (20), eine Liftkabine (6), die in einem Liftschacht (11) zwischen Schachtdecke (12) und Schachtboden (13) mittels des Antriebs (20) auf mehrere Stockwerke (1-4) verfahrbar ist, umfasst. Dabei verfügt die Liftkabine (6) über einen Kabinenboden (7), der zumindest partiell mittels mindestens einem eine Öffnung (9) freigebbaren Bodenelement (8) öffnenbar ist. Desweiteren umfasst der Lift (10) eine Verriegelungseinheit (30), mit der das mindestens eine Bodenelement (8) am Kabinenboden (7) verriegelbar ist. Die Erfindung zeichnet sich dadurch aus, dass der Lift (10) über eine Entriegelungseinheit (35) verfügt, durch welche die Verriegelungseinheit (30) entriegelbar bzw. für eine Entriegelung freigebbar ist, wenn die Liftkabine (6) eine Endposition (14) im Bereich des untersten Stockwerks (1) erreicht.

## Beschreibung

Die Erfindung betrifft einen Lift mit einer Liftkabine, die eine Wartungsöffnung im Kabinenboden aufweist.

Üblicherweise wird eine Liftkabine in einem Liftschacht zwischen zwei Endpositionen, nämlich einer ersten oberen Endposition im Bereich einer Schachtdecke und einer zweiten unteren Endposition im Bereich eines Schachtbodens verfahren. Meistens sind die Bereiche unterhalb oder oberhalb einer Liftkabine für Servicepersonal bei Wartungsarbeiten zugängig. Zur Vermeidung von Quetschunfällen sind zwischen dem Kabinenboden und der Schachtdecke sowie zwischen Kabinenboden und Schachtboden ausreichend grosse Schutzräume vorzusehen, in welchen sich das Servicepersonal jederzeit sicher aufhalten kann.

Die Einrichtung eines solchen Schutzraums unterhalb der Liftkabine fordert beispielsweise die Bereitstellung einer relativ tiefen Schachtgrube. Dem steht entgegen, dass ein gegebenes Gebäudevolumen möglichst effizient zu nutzen ist. Darum gilt es bei der Auslegung eines Lifts eine solche Schachtgrube raumsparend zu realisieren. Dieser Problematik wurde in der Patentschrift WO 01/89977 A1 Rechnung getragen.

WO 01/89977 A1 zeigt einen Lift mit einer Liftkabine, die über eine Wartungsöffnung im Bereich des Kabinenbodens verfügt. Dementsprechend ist die Schachtgrube für Wartungsarbeiten über die Wartungsöffnung zugänglich. Da die Wartungsöffnung während dem Aufenthalt von Servicepersonal in der Schachtgrube offen bleibt, erstreckt sich nun der Schutzraum vom Schachtboden bis zur Unterseite des Kabinendachs. Folglich ist kein zusätzlicher Schutzraum unterhalb der Liftkabine vorzusehen und die Schachtgrubentiefe kann minimal ausgelegt werden.

Bei einer Liftkabine mit Wartungsöffnung im Kabinenbodenbereich sind besondere Vorsichtsmassnahmen zu berücksichtigen. Denn die Wartungsöffnung darf nur dann geöffnet werden, wenn ein sicheres Betreten des Schachtbodens möglich ist. Dies ist einzig in der unteren Endposition der Liftkabine gewährleistet. Wird die Wartungsöffnung bei einer oberen Position der Liftkabine im Schacht geöffnet, ist ein Sturz aus der Liftkabine auf den Schachtboden mit einem erheblichen Verletzungsrisiko verbunden.

Daher ist es die Aufgabe der vorliegenden Erfindung einen Lift mit Liftkabine, die über eine Wartungsöffnung im Bereich des Kabinenbodens verfügt möglichst sicher zu gestalten.

Die Aufgabe wird von einem Lift gelöst, der einen Antrieb und eine Liftkabine umfasst, die in einem Liftschacht zwischen Schachtdecke und Schachtboden mittels des Antriebs auf mehrere Stockwerke verfahrbar ist. Dabei verfügt die Liftkabine über einen Kabinenboden, der zumindest partiell mittels mindestens einem eine Öffnung freigebbaren Bodenelement öffnenbar ist. Zudem umfasst der Lift eine Verriegelungseinheit, mit der das mindestens eine Bodenelement am Kabinenboden verriegelbar ist. Der Lift zeichnet sich dadurch aus, dass er über eine Entriegelungseinheit verfügt, durch welche die Verriegelungseinheit entriegelbar bzw. für eine Entriegelung freigebbar ist, wenn die Liftkabine eine Endposition im Bereich des untersten Stockwerks erreicht.

Von Vorteil erweist sich hier, dass die Verriegelungseinheit nur im Bereich des untersten Stockwerks entriegelbar ist. Damit ist ein sicherer Betrieb des Lifts, insbesondere bei wartungsbedingten Arbeiten im Bereich des Schachtbodens sichergestellt. Denn die Öffnung im Kabinenboden kann nur in der dazu vorgesehenen Endposition im Bereich des untersten Stockwerks geöffnet werden, um einen Zugang auf den Schachtboden freizugeben. Ein Sturz eines Servicetechnikers aus der Liftkabine bei verfrühtem Öffnen des Kabinenbodens ist somit verhindert.

Unter einem Bodenelement ist hier ein Element zu verstehen, das geeignet ist eine Öffnung im Kabinenboden abzudecken. Das Bodenelement bzw. seine Anschlüsse zum Kabinenboden sind dermassen zu dimensionieren, dass es eine vorgesehene Nutzlast oder zumindest anteilsmässig zur Gesamtfläche des Kabinenbodens einen Teil der Nutzlast der Liftkabine trägt. Als Bodenelement sind beispielsweise Panele, Rollböden, Sandwich-Platten, abgedeckte Gitterroste und dergleichen einsetzbar.

Unter Verriegelungseinheit ist hier eine Einheit zu verstehen, die zumindest ein Verriegelungselement wie beispielsweise einen Riegel, einen Bolzen, einen Stift oder dergleichen umfasst. Das Verriegelungselement kann eine geschlossene oder geöffnete Stellung einnehmen. In der geschlossenen Stellung ist das Bodenelement gegenüber dem Kabinenboden festgehalten. In der geöffneten Stellung hingegen ist das Bodenelement aus der Öffnung des Kabinenbodens wegnehmbar, schwenkbar, schiebbar oder dergleichen. Vorzugsweise umfasst die Verrieglungseinheit zudem einen Verriegelungsmechanismus, mit welchem das Verriegelungselement in eine geschlossene oder geöffnete Stellung bringbar ist oder mit welchem das Verriegelungselement für eine Entriegelung freigebbar ist.

Unter Entriegelungseinheit ist hier eine Einheit zu verstehen, die bei Erreichen der Endposition durch die Liftkabine den Verriegelungsmechanismus der Verriegelungseinheit in Bewegung setzt bzw. den Verriegelungsmechanismus für eine Bewegung freigibt.

Vorzugsweise ist die Entriegelungseinheit im unteren Bereich des Liftschachts dermassen angeordnet, dass beim Einfahren der Liftkabine in die Endposition die Entriegelungseinheit in Wechselwirkung mit der Verriegelungseinheit tritt. Dabei ist die Verriegelungseinheit entriegelbar bzw. für eine Entriegelung freigebbar.

Die Wechselwirkung zwischen der Entriegelungseinheit und der Verriegelungseinheit, die zur Entriegelung der Verriegelungseinheit führt, kann auf unterschiedlichen technischen Prinzipien basieren.

Bei einer mechanischen Wechselwirkung setzt die Entriegelungseinheit beispielsweise einen Mechanismus der Verriegelungseinheit in Bewegung, der einen Bolzen, Riegel oder dergleichen der Verriegelungseinheit in eine offene Position verschiebt. Hierbei wird die Bewegungsenergie der Liftkabine in eine Bewegung des Mechanismus umgesetzt.

Alternativ dazu ist der Mechanismus dazu ausgelegt ein Schloss der Verriegelungseinheit, das vom Innern der Liftkabine aus betätigbar ist, freizugeben. In freigegebenem Zustand kann das Schloss mit einem Schlüssel geöffnet werden, wobei durch die Aufschliessbewegung ein Bolzen oder ein Riegel in eine offene Position verschiebbar ist.

Es versteht sich, dass der Mechanismus der Verriegelungseinheit über einen Elektromotor verfügen kann, der den Bolzen oder Riegel direkt betätigt oder zum Öffnen freigibt. Hierbei kann die mechanische Wechselwirkung beispielsweise in eine Bewegung eines Schalters umgesetzt werden.

Die Wechselwirkung, die den obigen Mechanismus in Bewegung setzt, kann auch elektrischer, magnetischer oder elektromagnetischer Natur sein.

Bei einer elektrischen Wechselwirkung wird beispielsweise ein elektrischer Kontakt zwischen der Entriegelungseinheit und der Verriegelungseinheit geschlossen, der einen Elektromotor der Verriegelungseinheit speist. Der Elektromotor treibt bei geschlossenem Kontakt den Mechanismus der Verriegelungseinheit an.

Bei einer magnetischen Wechselwirkung, verfügt beispielsweise die Entriegelungseinheit über einen Magneten und die Verrieglungseinheit über einen Hallsensor, der das vom Magneten erzeugte Magnetfeld detektiert. Eine an den Hallsensor angeschlossene Auswerteelektronik wertet die Signale des Hallsensors aus und kann bei entsprechender Annäherung der Verriegelungseinheit an die Entriegelungseinheit einen Elektromotor zur Betätigung des Mechanismus ansteuern.

Bei einer elektromagnetischen Wechselwirkung verfügt die Entriegelungseinheit beispielsweise über einen RFID-Tag und die Verriegelungseinheit über eine RFID-Leseeinheit. Bei entsprechender Annäherung des RFID-Tags an die RFID-Leseeinheit wird der RFID-Tag mittels induktiver Erregung mit Strom versorgt und übermittelt einen abgespeicherten Code an die RFID-Leseeinheit. Ein an die RFID-Leseeinheit angeschlossene Auswerteelektronik wertet den ausgelesenen Code aus und steuert bei einer positiven Auswertung des Codes einen Elektromotor zur Betätigung des Mechanismus an.

Selbstverständlich erschliessen sich dem Fachmann weitere Möglichkeiten eine Wechselwirkung zwischen der Entriegelungs- und der Verriegelungseinheit herbeizuführen, die dazu dienen die Verriegelungseinheit zu entriegeln bzw. für eine Entriegelung freizugeben.

Vorzugsweise tritt beim Einfahren der Liftkabine in die Endposition die Entriegelungseinheit in eine mechanische Wechselwirkung mit der Verriegelungseinheit. Dabei ist die Verriegelungseinheit entriegelbar bzw. für eine Entriegelung freigebbar.

Vorzugsweise ist das Einfahren der Liftkabine in die Endposition mittels einer Positionserfassungseinheit erfassbar, die als Entriegelungseinheit wirkt. Aufgrund dieser Positionserfassung ist die Verriegelungseinheit aktivierbar. Dabei ist die Verriegelungseinheit entriegelbar bzw. für eine Entriegelung freigebbar.

Von Vorteil ist dabei bereits vorhandene Aufzugskomponenten, wie ein Schachtendschalter oder ein Schachtinformationssystem zum Aktivieren der Verriegelungseinheit zu nutzen. Diese Aufzugskomponenten übernehmen hierbei auch die Funktion der Entriegelungseinheit.

Vorteilhaft ist der Zustand des mindestens einen Bodenelements mittels eines Sicherheitselements überwachbar, wobei bei offenem Zustand des mindestens einen Bodenelements ein Betrieb des Lifts unterbrechbar ist.

Von Vorteil ist hierbei, dass ein sicherer Betrieb des Lifts gewährleistet ist. Insbesondere kann bei geöffneten Bodenelementen die Liftkabine nicht in eine höhere Position im Liftschacht verfahren werden. Das Bodenelement ist also nur in der untersten Position entfernbar. Entsprechend ist ein Sturz eines Servicetechnikers beim Öffnen des Bodenelements verunmöglicht.

Üblicherweise ist das Sicherheitselement, das Bestandteil eines Sicherheitssystems ist, als Kontakt oder Schalter ausgelegt. Das Sicherheitssystem kann eine Sicherheitskette von seriell verbundenen Kontakten und/oder Schaltern umfassen. Bei geschlossener Sicherheitskette wird die Antriebseinheit des Lifts mit Energie versorgt. Bei geöffnetem Kontakt bzw. Schalter ist die Sicherheitskette unterbrochen. Dabei wird die Energiezufuhr zu einer Antriebseinheit unterbrochen bzw. ein Betrieb des Lifts unterbrochen.

Alternativ kann das Sicherheitssystem einen Sicherheitsbus und einen Sicherheitscontroller umfassen. Über einen Busknoten ist zumindest ein Kontakt und/oder Schalter mit dem Sicherheitsbus verbunden. Der Sicherheitscontroller fragt über den Sicherheitsbus den Zustand des mindestens einen Kontakts und/oder Schalters ab. Wenn der Sicherheitscontroller einen unsicheren Zustand eines Kontakts und/oder Schalters erfasst, sendet der Sicherheitscontroller ein Stoppsignal an die Antriebseinheit oder unterbricht die Energiezufuhr an die Antriebseinheit. Hierbei wird der Betrieb des Lifts unterbrochen.

Vorteilhaft ist die Position der Liftkabine in der Endposition mittels der Positionserfassungseinheit überwachbar, wobei eine unbeabsichtigte Kabinenfahrt bei offenstehender Öffnung mittels der Positionserfassungseinheit erfassbar ist und entsprechend eine Bremse aktivierbar ist, um die unbeabsichtigte Kabinenfahrt zu stoppen.

Hierbei ist von Vorteil, dass bei Wartungsarbeiten in der Schachtgrube bei geöffnetem Bodenelement, die Liftkabine wieder besteigbar ist. Insbesondere wird verhindert, dass die Liftkabine in eine höhere Position verfahren wird, in der ein Besteigen der Liftkabine unmöglich ist.

Die Bremse ist beispielsweise als Antriebsbremse ausgelegt und wirkt direkt auf den Anrieb, insbesondere auf seine Antriebswelle. Bei Aktivierung der Antriebsbremse kann eine ungewollte Drehbewegung des Antriebs verhindert werden. Alternativ dazu kann die Bremse als Kabinenbremse ausgelegt sein, wobei die Bremse an der Liftkabine befestigt ist und auf Führungsschienen der Liftkabine wirkt. Bei Aktivierung der Kabinenbremse wird die Liftkabine an den Führungsschienen festgehalten. So wird eine unbeabsichtigte Bewegung der Liftkabine verhindert.

Vorteilhaft ist der Lift mittels einer Bedienungseinheit wieder in Betrieb nehmbar und dabei in einen Wartungsmodus bringbar.

Im Wartungsmodus sind Fahrten der Liftkabine in einem beschränkten Umfang möglich. So kann die Liftkabine in eine höhere Position verfahren werden, um ansonsten schwer zugängliche zu wartende Komponenten, wie beispielsweise seitlich stehende Puffer oder Führungsschienen, zu erreichen. Zudem sind im unteren Bereich der Liftkabine angeordnete Komponenten wie Beispielsweise eine Fangbremse oder ein Aufhängungspunkt der Liftkabine ebenfalls besser erreichbar.

Die Bedienungseinheit kann ein Schaltpanel mit Steuerelementen umfassen. Die Bedienungseinheit ist mit einer Aufzugsteuerung des Lifts verbunden. Die Bedienungseinheit kann bereits vorgängig mit der Aufzugsteuerung in Verbindung stehen und im Bereich der Liftkabine unter einer Abdeckung anbringbar sein. In dieser Ausgestaltung ist die Bedienungseinheit über ein Kabel an der Liftkabine angeordnet, wobei das Kabel zumindest so lang ist, dass ein Wartungstechniker vom Schachtboden aus den Lift über die Bedienungseinheit bedienen kann. Alternativ ist die Bedienungseinheit als mobiles Gerät auslegbar, das über eine Schnittstelle in der Liftkabine oder über ein kabelloses Netzwerk mit der Aufzugssteuerung verbindbar ist.

Über die Bedienungseinheit ist zumindest das Sicherheitselement des Bodenelements rücksetzbar. Zudem sind über die Bedienungseinheit Steuerbefehle im Wartungsmodus an die Aufzugssteuereinheit sendbar.

Vorteilhaft ist die Liftkabine mittels der Bedienungseinheit gesteuert von der Endposition in eine Wartungsposition verfahrbar, wobei die Wartungsposition oberhalb der Endposition angeordnet ist.

Die Wartungsposition ist eine Position, in der die zu wartenden Komponenten des Lifts im Bereich des Schachtbodens möglichst gut erreichbar sind und ein ergonomisches und effizientes Arbeiten der Wartungstechniker möglich ist.

Vorteilhaft ist die Position der Liftkabine in der Wartungsposition mittels der Positionserfassungseinheit überwachbar, wobei eine unbeabsichtigte Kabinenfahrt bei offenstehender Öffnung mittels der Positionserfassungseinheit erfassbar ist und entsprechend eine Bremse aktivierbar ist, um die unbeabsichtigte Kabinenfahrt zu stoppen.

Analog zur Endposition ist auch die Wartungsposition der Liftkabine überwachbar. Hierbei sind sowohl Kabinenfahrten in den Arbeitsbereich hinein wie auch von Arbeitsbereich weg verhinderbar. So wird sichergestellt, dass sowohl ein Wartungstechniker nicht ungewollt zwischen Liftkabine und Schachtboden gequetscht wird, als auch ein mit der Liftkabine verbundene Bedienungseinheit sich aus dem Bedienungsbereich des Wartungstechnikers entfernt.

Vorteilhaft weist die Öffnung eine Dimension von mindestens 50 auf 60 cm.

Damit ist sichergestellt, dass ein Wartungstechniker sicher und bequem aus der Öffnung der Liftkabine auf den Schachtboden und wieder zurück in die Liftkabine steigen kann.

Vorteilhaft ist die Lage der Öffnung am Kabinenboden auf dem Schachtboden mittels Anzeigemittel anzeigbar.

Dies erleichtert das Erkennen eines sicheren Arbeitsbereichs für den Wartungstechniker auf dem Schachtboden, insbesondere bei einer Fahrt der Liftkabine von der Wartungsposition in die Endposition. Während dieser Fahrt im Wartungsmodus kann sich der Wartungstechniker schnell in diesen sicheren und einfach erkennbaren Arbeitsbereich begeben.

Als Anzeigemittel eignet sich beispielsweise eine mittels Farbe, Klebeband, Klebefolie oder dergleichen auf den Schachtboden aufgetragene Kontur der Öffnung im Kabinenboden. Selbstverständlich kann auch eine Lichtquelle als Anzeigemittel dienen, mit welcher der sichere Arbeitsbereich auf dem Schachtboden projizierbar ist. Anstatt der Kontur ist auch die Stehfläche der Öffnung oder die ausserhalb der Öffnung liegende Fläche visuell kennzeichenbar.

In den Zeichnungen ist das Prinzip aufgezeigt und wird anhand derselben nachfolgend erläutert.

Es zeigen:
- Fig. 1:: Einen Lift mit vier Erschliessungsebenen;
- Fig. 2:: Diesen Lift mit einer Liftkabine, die am Kabinenboden eine Wartungsöffnung aufweist, die mittels einer mechanisch aktivierbaren Verriegelungseinheit verriegelbar ist;
- Fig. 3:: Diesen Lift mit einer Liftkabine, die am Kabinenboden eine Wartungsöffnung aufweist, die mittels einer magnetisch aktivierbaren Verriegelungseinheit verriegelbar ist.
- Fig. 4:: Diesen Lift mit Anzeigemitteln, die die Wartungsöffnung am Kabinenboden auf dem Schachtboden anzeigen.

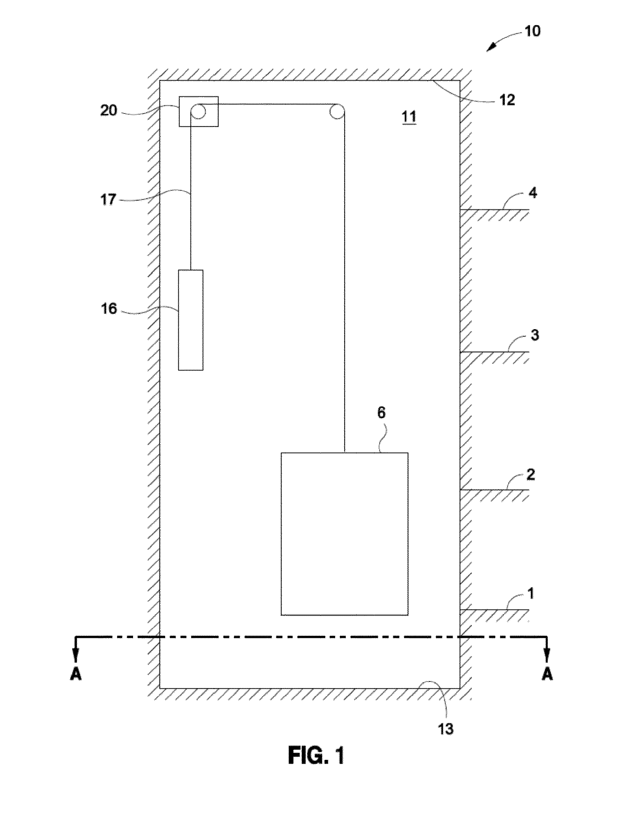

Fig. 1 zeigt einen Lift 10, der über eine Liftkabine 6 und einen Antrieb 20 verfügt. Die Liftkabine 6 wird mittels des Antriebs 20 entlang einer Fahrbahn auf mehrere Stockwerke 1 bis 4 verfahren. Die Fahrbahn ist hier in einem Liftschacht 11 untergebracht, der durch vier Seitenwände, eine Schachtdecke 12 und einen Schachtboden 13 begrenzt ist. Üblicherweise ist die Liftkabine 6 an Kabinenführungsschienen geführt, die in Fig. 1 nicht gezeigt sind.

Die Antriebsleistung des Antriebs 20 wird durch eine mit dem Antrieb 20 wirkverbundene Treibscheibe auf ein Tragmittel 17 übertragen. Am einen Ende des Tragmittels 17 ist die Liftkabine 6 aufgehängt. Zum Ausgleich des Gewichts der Liftkabine 6 ist ein Gegengewicht 16 vorgesehen, das an einem zweiten Ende des Tragmittels 17 aufgehängt ist. Selbstredend ergeben sich dem Fachmann neben der gezeigten 1:1 Aufhängung der Liftkabine 6 und des Gegengewichts 16 auch davon abweichende Lösungsmöglichkeiten, in denen Aufhängungsverhältnisse von 2:1 und mehr gewählt. Desweiteren ist der Lift auch gegengewichtslos realisierbar. Als Tragmittel 17 eignen sich Seile, Riemen oder dergleichen.

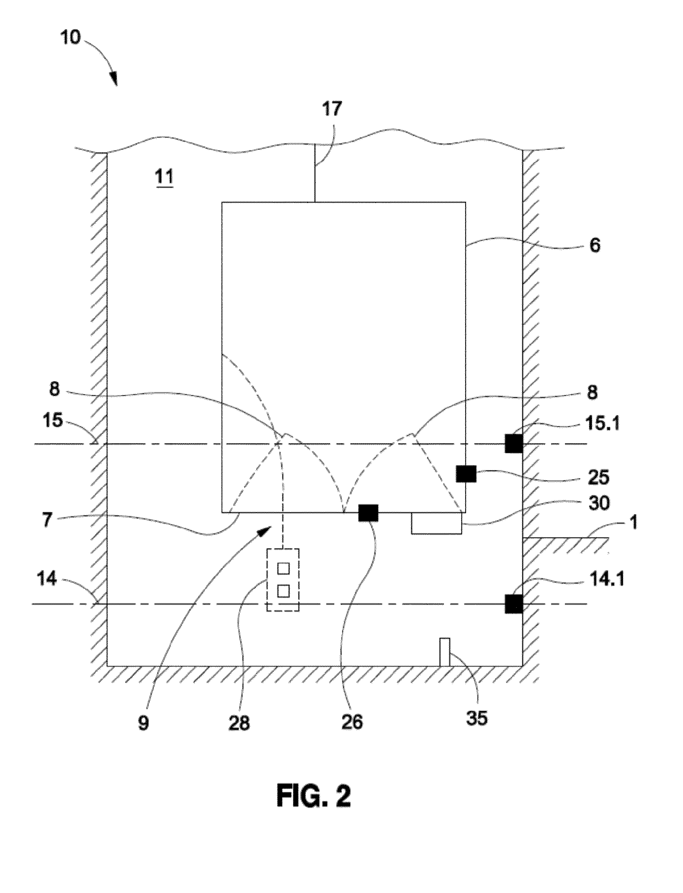

Die Fig. 2 stellt ein erstes Ausführungsbeispiel des Lifts 10 dar. Die Liftkabine 6 verfügt über zwei Bodenelemente 8 die als Flügelpanele scharnierend am Kabinenboden 7 befestigt sind. In einer horizontalen Lage der Bodenelemente 8 ist eine Öffnung 9 im Kabinenboden 7 abgedeckt. Die beiden Bodenelemente 8 sind in eine vertikale Lage schwingbar, in der die Bodenelemente 8 die Öffnung 9 freigeben.

Desweiteren ist eine Verriegelungseinheit 30 im Bereich des Kabinenbodens 7 an der Liftkabine 6 angeordnet. Mittels dieser Verriegelungseinheit 30 sind die Bodenelemente 8 am Kabinenboden 7 verriegelbar. Dazu umfasst die Verriegelungseinheit 30 mindestens über ein Verriegelungselement, wie beispielsweise einen Riegel, der in seinem geschlossenen Zustand einen schwenkbaren Bereich der Bodenelemente 8 am Kabinenboden 7 verriegelt.

Die Liftkabine 6 hält sich gemäss Fig. 1 im Bereich des untersten Stockwerks 1 auf und ist im Begriff, eine Endposition 14 zu erreichen. In dieser Endposition 14 ist die Verriegelungseinheit 30 durch eine Entriegelungseinheit 35 entriegelbar bzw. für eine Entriegelung freigebbar. Die Entriegelungseinheit 35 ist dazu auf dem Schachtboden 13 dermassen angeordnet, dass in der Endposition 14 der Liftkabine 6 die Entriegelungseinheit 35 in eine Wechselwirkung mit der Verriegelungseinheit 30 tritt, durch welche die Verriegelungseinheit 30 erst entrieglet bzw. für eine Entriegelung freigebbar wird.

Im gezeigten Ausführungsbeispiel nach Fig. 1 ist die Entriegelungseinheit 35 als Stift, Rohr, Dorn oder dergleichen ausgelegt, der vertikal vom Schachtboden 13 in das Innere des Liftschachts 11 hineinragt und der in mechanische Wechselwirkung mit der Verriegelungseinheit 30 tritt. Dabei wird der Stift 35 in eine Einführungsöffnung der Verriegelungseinheit 30 geführt und setzt einen Mechanismus der Verriegelungseinheit 30 in Bewegung. Der Mechanismus setzt entweder den Riegel unmittelbar in seine offene Stellung oder gibt den Riegel für eine spätere manuelle Betätigung frei.

Ein sich in der Liftkabine 6 aufhaltender Servicetechniker kann nun bei automatischer Öffnung des Riegels die Bodenelemente 8 in das Innere der Liftkabine 6 aufschwingen und die Öffnung 9 im Kabinenboden 7 freigeben. Alternativ muss der Servicetechniker zuvor den zur Entriegelung freigegebenen Riegel manuell betätigen. Dazu führt der Wartungstechniker einen Dreikantschlüssel in eine von der Verriegelungseinheit 30 freigegebene Öffnung ein und bringt den Riegel mittels Drehbewegung des Dreikantschlüssels und entsprechender Betätigung eines Schlossmechanismus in eine offene Stellung. Die Freigabe des Schlossmechanismus des Riegels kann auch durch die Verriegelungseinheit 30 über eine Enthemmung des Schlossmechanismus erfolgen. Dabei kann die Öffnung zur Einführung des Dreikantschlüssels in den Schlossmechanismus auch bei nicht aktiviertem Verriegelungselement 30 offen stehen.

An der Liftkabine 6 ist ein Sicherheitselement 26 vorgesehen, um einen sicheren Betrieb des Lifts 10 bei geöffnetem Kabinenboden 7 zu gewährleisten. Das Sicherheitselement 26 überwacht den Öffnungszustand der Bodenelemente 8. Das Sicherheitselement 26 kann dabei als elektromechanischer Schalter oder Kontakt ausgelegt sein. Beim Aufschwingen der Bodenelemente 8 wird das Sicherheitselement 26 geöffnet. Das Sicherheitselement 26 ist Teil eines Sicherheitssystems, das bei geöffnetem Sicherheitselement 26 den Betrieb des Lifts 10 unterbricht. Das Sicherheitssystem ist in Fig. 2 nicht gezeigt.

Das Sicherheitssystem kann als klassische Sicherheitskette ausgelegt sein, in der das Sicherheitselement 26 eines von mehreren in Serie geschalteten Sicherheitselementen ist. Bei geöffnetem Sicherheitselement 26 ist die Sicherheitskette unterbrochen und damit die Stromzufuhr zum Antrieb 20 und einer zugeordneten Haltebremse verhindert. Dies bewirkt einen Betriebsunterbruch des Lifts 10, während dessen der Wartungstechniker die Liftkabine 6 aus der Öffnung 9 im Kabinenboden 7 sicher verlassen kann.

Alternativ dazu kann das Sicherheitssystem einen Sicherheitscontroller 31 und einen Sicherheitsbus 32 umfassen. Das Sicherheitselement 26 ist über einen Busknoten mit dem Sicherheitsbus 32 verbunden. Der Sicherheitscontroller 31 fragt den Status des Sicherheitselements 26 periodisch ab und setzt bei Erfassen eines geöffneten Sicherheitselements 26 den Antrieb 20 ausser Betrieb und aktiviert die zugeordnete Haltebremse.

Zudem wird die Lage der Liftkabine 6 in der Endposition 14 mittels einer Positionserfassungseinheit 25 überwacht. Die Positionserfassungseinheit 25 ist vorzugsweise an der Liftkabine 6 angeordnet und umfasst einen Sensor, beispielsweise einen Hallsensor, der dazu geeignet ist die Position eines Magneten zu erfassen, der im Bereich des Liftschachts 11 dermassen angeordnet ist, dass dieser die Endposition 14 anzeigt.

Wenn sich die Liftkabine 6 bei offenstehender Öffnung 9 aus dem Bereich der Endposition 14 bewegt, erfasst dies die Positionserfassungseinheit 25 und aktiviert eine Kabinenbremse 21.

Zudem verfügt der Lift 10 über eine Bedienungseinheit 28, die vorzugsweise über ein Signalübertragungskabel mit der Liftkabine 6 verbunden ist. Das Kabel verbindet beispielsweise die Bedienungseinheit 28 mit einem Kabinenbedienungspanel, an welchem Zielstockwerke eingebbar sind. Über dieses Kabinenbedienungspanel ist die Bedienungseinheit 28 desweiteren mit einer Aufzugssteuerung verbunden. Die Bedienungseinheit 28 kann mit dem Kabinenbedienungspanel fix verbunden und hinter einer Abdeckung in der Liftkabine 6 gelagert sein.

Alternativ dazu kann die Bedienungseinheit 28 vom Servicetechniker mitgebracht werden und beispielsweise über eine Schnittstelle mit dem Kabinenbedienungspanel verbunden werden.

Das Signalübertragungskabel ist vorzugsweise so lang, dass die Bedienungseinheit 28 bei offenem Kabinenboden 7 bis in den Arbeitsbereich des Wartungstechnikers unter der Liftkabine 6 hängt.

Selbstverständlich kann die Bedienungseinheit 28 auch über ein kabelloses Netzwerk mit der Aufzugssteuerung verbunden sein.

Über die Bedienungseinheit 28 ist der Lift 10 in einen Wartungsmodus bringbar, in dem die Liftkabine 6 zumindest in eine Wartungsposition 15 verfahrbar ist, die oberhalb der Endposition 14 liegt.

Optional kann diese Wartungsposition 15 mittels der Positionserfassungseinheit 25 überwacht werden.

Dazu ist ein weiterer Magnet im Liftschacht 11 dermassen angeordnet, dass der weitere Magnet die Wartungsposition 15 anzeigt. Wenn die Liftkabine 6 bei der Fahrt in die Wartungsposition 15 oder bei einer unbeabsichtigten Fahrt danach bei offenstehender Öffnung 9 die Wartungsposition 15 überfährt, wird dies von der Positionserfassungseinheit 25 erfasst, die den Lift 10 ausser Betrieb setzt, indem der Antrieb 20 abgestellt und die zugeordnete Haltebremse aktiviert wird. Damit wird sichergestellt, dass sich die Liftkabine 6 nicht in einen für den Servicetechniker unerreichbaren Bereich des Liftschachts 11 gelangt.

Zudem kann die Positionserfassungseinheit 25 die Position der Liftkabine 6 nach Erreichen der Wartungsposition 15 überwachen und eine ungewollte Abwärtsfahrt der Liftkabine 6 aus der Wartungsposition 15 verhindern.

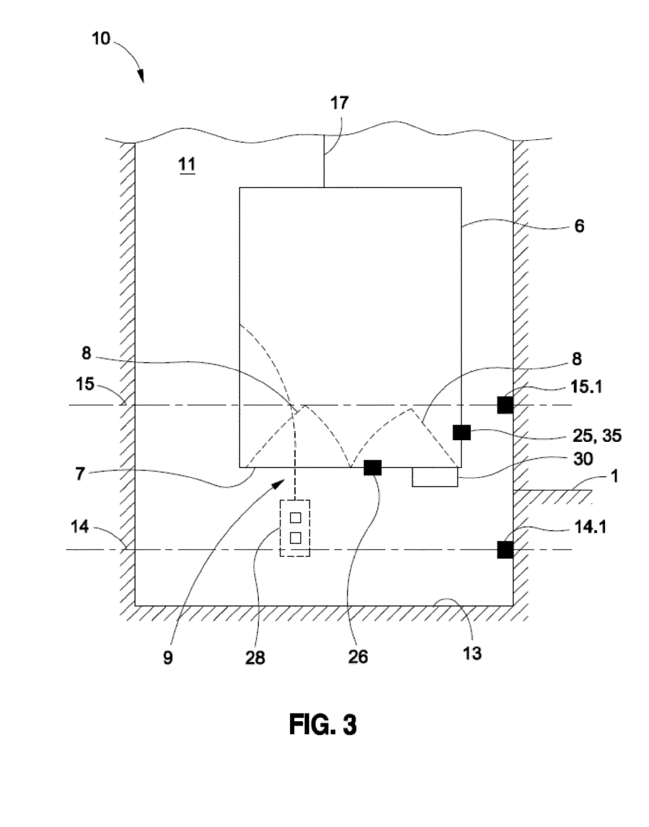

In Fig. 3 ist ein zweites Ausführungsbeispiel dargestellt. Darin ist die Verriegelungseinheit 30 durch die Positionserfassungseinheit 25 entriegelbar bzw. für eine Entriegleung freigebbar, sobald die Positionserfassungseinheit 25 die Endposition 14 erfasst hat. Dabei übernimmt die Positionserfassungseinheit 25 die Funktion der Entriegelungseinheit 35 aus dem ersten Ausführungsbeispiel.

Die Verriegelungseinheit 30 nach Fig. 3 verfügt über einen Motor der einen Mechanismus in Bewegung setzt. Aufgrund der erfassten Endposition 14 sendet die Positionserfassungseinheit 25 ein Signal an den Motor, um den Mechanismus in Bewegung zu setzt und so den Riegel direkt in einen offenen Zustand zu bringen oder den Riegel für eine spätere manuelle Betätigung freizugeben. Das Öffnen des Kabinenbodens 7 erfolgt analog zum ersten Ausführungsbeispiel. Die Überwachung des Öffnungszustands der Bodenelemente 8 mittels Sicherheitselement 26, der Endposition 14 und Wartungsposition 15 mittels der Positionserfassungseinheit 25 sowie die Bedienung des Lifts mittels der Bedienungseinheit 28 sind selbstredend auch im zweiten Ausführungsbeispiel realisierbar.

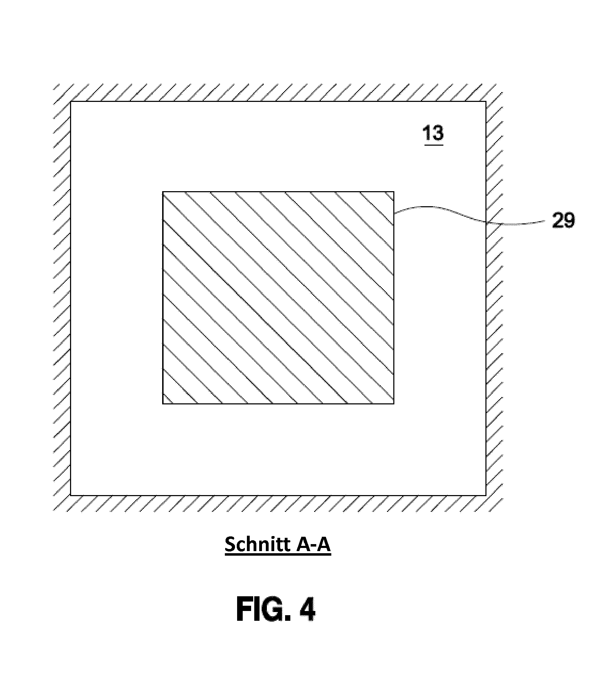

Fig. 4 zeigt ein Anzeigemittel 29, mit welchem die Lage der Öffnung 9 am Kabinenboden 7 auf dem Schachtboden 13 angezeigt wird. Als Anzeigemittel 29 dienen beispielsweise Klebbänder, die eine senkrecht nach unten projizierte Standfläche der Öffnung 9 am Schachtboden 13 visualisiert. Selbstverständlich kann diese Standfläche auch mittels aufgetragener Farbe, Klebefolien oder aus einer Lichtquelle projiziertem Licht am Schachtboden 13 angezeigt werden.

## Patentansprüche

1. Lift (10) mit einem Antrieb (20), mit einer Liftkabine (6), die in einem Liftschacht (11) zwischen Schachtdecke (12) und Schachtboden (13) mittels des Antriebs (20) auf mehrere Stockwerke (1-4) verfahrbar ist, wobei die Liftkabine (6) über einen Kabinenboden (7) verfügt, der zumindest partiell mittels mindestens einem eine Öffnung (9) freigebbaren Bodenelement (8) öffnenbar ist, und mit einer Verriegelungseinheit (30) mit der das mindestens eine Bodenelement (8) am Kabinenboden (7) verriegelbar ist, ***dadurch gekennzeichnet,* dass** der Lift (10) über eine Entriegelungseinheit (35) verfügt, durch welche die Verriegelungseinheit (30) entriegelbar bzw. für eine Entriegelung freigebbar ist, wenn die Liftkabine (6) eine Endposition (14) im Bereich des untersten Stockwerks (1) erreicht.

2. Lift (10) nach Anspruch 1, ***dadurch gekennzeichnet,* dass** die Entriegelungseinheit (35) im unteren Bereich des Liftschachts (11) dermassen angeordnet ist, dass beim Einfahren der Liftkabine (6) in die Endposition (14) die Entriegelungseinheit (35) in Wechselwirkung mit der Verriegelungseinheit (30) tritt und die Verriegelungseinheit (30) dabei entriegelbar bzw. für eine Entriegelung freigebbar ist.

3. Lift (10) nach Anspruch 2, ***dadurch gekennzeichnet,* dass** beim Einfahren der Liftkabine (6) in die Endposition (14) die Entriegelungseinheit (35) in eine mechanische Wechselwirkung mit der Verriegelungseinheit (30) tritt und dabei die Verriegelungseinheit (30) entriegelbar bzw. für eine Entriegelung freigebbar ist.

4. Lift (10) nach Anspruch 2, ***dadurch gekennzeichnet,* dass** das Einfahren der Liftkabine (6) in die Endposition (14) mittels einer Positionserfassungseinheit (25) erfassbar ist, die als Entriegelungseinheit (35) wirkt, und Aufgrund dieser Positionserfassung die Verriegelungseinheit (30) entriegelbar bzw. für eine Entriegelung freigebbar ist.

5. Lift (10) nach einem der Ansprüche 1 bis 4, ***dadurch gekennzeichnet,* dass** der Zustand des mindestens einen Bodenelements (8) mittels eines Sicherheitselements (26) überwachbar ist, wobei bei offenem Zustand des mindestens einen Bodenelements (8) ein Betrieb des Lifts (10) unterbrechbar ist.

6. Lift (10) nach einem der vorhergehenden Ansprüche, ***dadurch gekennzeichnet,* dass** die Position der Liftkabine (6) in der Endposition (14) mittels der Positionserfassungseinheit (25) überwachbar ist, wobei eine unbeabsichtigte Kabinenfahrt bei offenstehender Öffnung (9) mittels der Positionserfassungseinheit (25) erfassbar ist und entsprechend eine Bremse (21, 22) aktivierbar ist, um die unbeabsichtigte Kabinenfahrt zu stoppen.

7. Lift (20) nach einem der Ansprüche 5 oder 6, **dadurch gekennzeichnet, dass** der Lift (10) mittels einer Bedienungseinheit (28) wieder in Betrieb nehmbar ist und dabei in einen Wartungsmodus bringbar ist.

8. Lift (10) nach einem der Ansprüche 5 bis 7, **dadurch gekennzeichnet, dass** die Liftkabine (6) mittels der Bedienungseinheit (28) gesteuert von der Endposition (14) in eine Wartungsposition (15) verfahrbar ist, wobei die Wartungsposition (15) oberhalb der Endposition (14) angeordnet ist.

9. Lift (10) nach Anspruch 8, ***dadurch gekennzeichnet,* dass** die Position der Liftkabine (6) in der Wartungsposition (15) mittels der Positionserfassungseinheit (25) überwachbar ist, wobei eine unbeabsichtigte Kabinenfahrt bei offenstehender Öffnung (9) mittels der Positionserfassungseinheit (25) erfassbar ist und entsprechend ein Betrieb des Lifts (10) unterbrechbar ist.

10. Lift (10) nach einem der vorangehenden Ansprüche, ***dadurch gekennzeichnet,* dass** die Öffnung (9) eine Dimension von mindestens 50 auf 60 cm aufweist.

11. Lift (10) nach einem der vorangehenden Ansprüche, ***dadurch gekennzeichnet,* dass** die Lage der Öffnung (9) am Kabinenboden (7) auf dem Schachtboden (13) mittels Anzeigemittel (29) anzeigbar ist.
